# EUROPÄISCHE PATENTSCHRIFT

(11) **EP 1 334 330 B1**
(45) Veröffentlichungstag und Bekanntmachung des Hinweises auf die Patenterteilung: **28.04.2010**
(21) Anmeldenummer: 01982293.1
(22) Anmeldetag: 15.09.2001
(51) Int. Cl.: G01D 5/244

(54) **POSITIONSMESSGERÄT UND VERFAHREN ZUR BESTIMMUNG EINER POSITION**
POSITION MEASURING DEVICE AND METHOD FOR DETERMINING A POSITION
APPAREIL DE MESURE DE POSITION ET PROCÉDÉ POUR DÉTERMINER UNE POSITION

(30) Priorität: 31.10.2000 DE 10054070
(43) Veröffentlichungstag der Anmeldung: 13.08.2003
(73) Patentinhaber: Dr. Johannes Heidenhain GmbH, 83292 Traunreut (DE)
(72) Erfinder: HUBER-LENK, Herbert, 83365 Nussdorf/Sondermoning (DE); DRESCHER, Jörg, 83083 Riedering (DE); HAUSSCHMID, Mathias, 83349 Palling (DE); REITER, Herbert, 84518 Garching/Alz (DE); STREITWIESER, Johann, 83355 Grabenstätt (DE); HOLZAPFEL, Wolfgang, 83119 Obing (DE)
(86) Internationale Anmeldenummer: PCT/EP2001/010682
(87) Internationale Veröffentlichungsnummer: WO 2002/039066

(56) Entgegenhaltungen:
- US-A- 5 391 970
- PATENT ABSTRACTS OF JAPAN vol. 017, no. 672 (E-1474), 10. Dezember 1993 (1993-12-10) & JP 05 226232 A (HITACHI LTD), 3. September 1993 (1993-09-03)

## Beschreibung

Die Erfindung betrifft ein Positionsmeßgerät, insbesondere zur Verwendung in einem Lithographiesystem. Die Erfindung betrifft außerdem ein Verfahren zur Positionsbestimmung in einem Positionsmeßgerät.

Mit einem Positionsmeßgerät in einem Lithographiesystem muß die Position eines beweglichen Objektes so bestimmt werden können, daß sowohl der Zeitpunkt der Messung als auch die Lage des beweglichen Objektes sehr genau feststehen. Ein nach dem Scannerprinzip arbeitendes Lithographiesystem bewegt beispielsweise einen Wafertisch und einen Photomaskentisch relativ zueinander, und belichtet dabei jeweils nur einen Teil des abzubildenden Bereiches der Photomaske auf einen Wafer. Räumliche oder zeitliche Fehler in der Positionierung, und damit in der Positionsbestimmung, führen zu Überlagerungsfehlern der abzubildenden Strukturen relativ zu den bereits auf dem Wafer vorhanden Strukturen.

In einem solchen Lithographiesystem wird von einer zentralen Steuerung jeweils zu bestimmten Zeiten (z.B. alle 50 µs) ein Positionswert von einem Postionsmeßgerät angefordert, das dann als Antwort die Position des beweglichen Objektes (z.B. des Maskentisches) zum Zeitpunkt der Positionswertanforderung ausgeben muß. Aufgrund der heute üblichen hohen Verfahrgeschwindigkeiten (etwa 2m/s für den Maskentisch) bedeutet dabei eine Ungenauigkeit von einer Nanosekunde in der zeitlichen Erfassung des Positionswertes eine Fehler von zwei Nanometern in der Positionsbestimmung, was in etwa den Anforderungen an ein solches Positionsmeßgerät entspricht.

Aus der US 5391970 ist ein Antriebssystem mit mehreren Antrieben in einer Master - Slave Konfiguration bekannt. Positionsdaten mit Zeitstempeln werden vom Master an den Slave gesandt. Der Slave kann anhand dieser Daten die Geschwindigkeit des Masters berechnen. Aus einer lediglich geschätzten, mittleren Übertragungszeit dieser Daten berechnet der Slave dann eine aktuelle Position des Masters durch eine Extrapolation. Dieser Wert kann aber schon deshalb nicht besonders genau sein, da die herangezogene Zeit lediglich ein Schätzwert ist. Eine Abfrage einer Position, die ein Antrieb zu einem bestimmten, von außen festgelegten Zeitpunkt eingenommen hat, ist nicht möglich.

Aufgabe der Erfindung ist es daher, ein Positionsmeßgerät anzugeben, das die Position eines beweglichen Objektes zu einem von außen festgelegten Zeitpunkt bestimmen und danach ausgeben kann.

Diese Aufgabe wird gelöst durch eine Vorrichtung mit den Merkmalen des Anspruches 1. Vorteilhafte Ausführungsformen ergeben sich aus den Merkmalen, die in den von Anspruch 1 abhängigen Ansprüchen aufgeführt sind.

Weiter ist es Aufgabe der Erfindung, ein Verfahren anzugeben, daß es erlaubt, die Position eines beweglichen Objektes zum Zeitpunkt einer Positionsanforderung sehr genau zu bestimmen und anschließend zur Weiterverarbeitung zur Verfügung zu stellen.

Diese Aufgabe wird gelöst durch eine Verfahren mit den Merkmalen des Anspruches 3. Vorteilhafte Details des Verfahrens ergeben sich aus den Maßnahmen, die in den von Anspruch 3 abhängigen Ansprüchen aufgeführt sind.

Das Prinzip der Erfindung beruht nun darauf, die Position des beweglichen Objektes in von einem internen Takt des Positionsmeßgerätes vorgegebenen Intervallen zu bestimmen, bei Eintreffen einer Positionsanforderung (Triggersignal) von einer Steuerungseinheit den zeitlichen Abstand des Triggersignals von der letzten Positionsmessung zu bestimmen und einen Positionswert zum Zeitpunkt des Eingangs des Triggersignals aus mindestens zwei zuvor gemessenen Positionswerten zu extrapolieren. Dieser extrapolierte Positionswert wird dann als Antwort auf die Positionsanforderung ausgegeben.

Weitere Vorteile sowie Einzelheiten der vorliegenden Erfindung ergeben sich aus der nachfolgenden Beschreibung einer bevorzugten Ausführungsform anhand der Figuren. Dabei zeigt
- Figur 1: ein Positionsmeßgerät
- Figur 2: ein Diagramm mit der zeitlichen Abfolge der Positions-bestimmung.

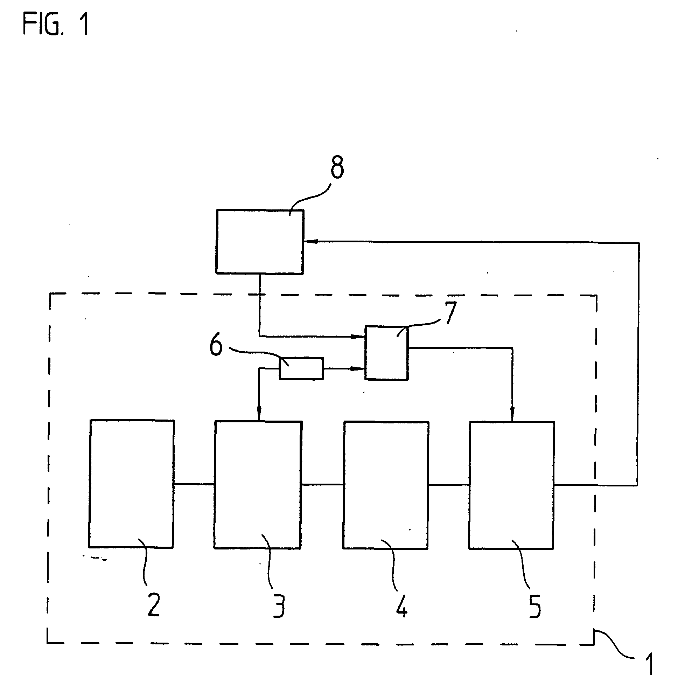

Figur 1 zeigt nun ein Positionsmeßgerät 1, dessen Komponenten und deren Funktionen im folgenden erklärt werden sollen. In einer Detektoreinheit 2 werden analoge Signale entsprechend dem verwendeten physikalischen Meßprinzip erzeugt. Dies können etwa die Signale eines Photodetektors sein, der moduliertes Licht von der Abtastung eines optischen Gittermeßsystems mit einer Inkrementalteilung und Referenzimpulsen empfängt. Die Verwendung von optischen Meßprinzipien bietet sich wegen der im oben beschriebenen Anwendungsfall geforderten hohen Auflösung an (so könnten auch die Signale eines Interferometers in der Detektoreinheit 2 erfaßt werden), prinzipiell kommen aber auch andere Meßverfahren in Frage, mit etwa auf magnetischen, induktiven oder kapazitiven Effekten beruhenden Abtastungen von sowohl linearen als auch rotatorischen Bewegungen. Die Detektoreinheit 2 erfaßt im beschriebenen Anwendungsfall lineare Bewegungen eines Maskentisches.

Die analogen Signale der Detektoreinheit 2 werden zu einem A/D-Wandler 3 geleitet. Dieser digitalisiert die analogen Signale jeweils zu von einem internen Takt 6 mit 1 MHz vorgegebenen Zeitpunkten t in Abständen von 1µs und gibt die digitalisierten Werte an eine Verarbeitungseinheit 4 weiter, wo aus diesen ein Positionswert berechnet wird. Die Positionsmessung in diesem schnellen Takt ist notwendig, um in einem inkrementalen Meßsystem ein Zählen der Inkremente zu ermöglichen. Es können in der Verarbeitungseinheit 4 auch Korrekturen etwa der Phasenlage der einzelnen digitalen Signale vorgenommen werden, ebenso kann die Auflösung der Positionsbestimmung durch Interpolation gesteigert werden. Durch die Auswertung von Referenzimpulsen und dem Zählen von Inkrementen der Signale kann eine absolute Positionsbestimmung vorgenommen werden.

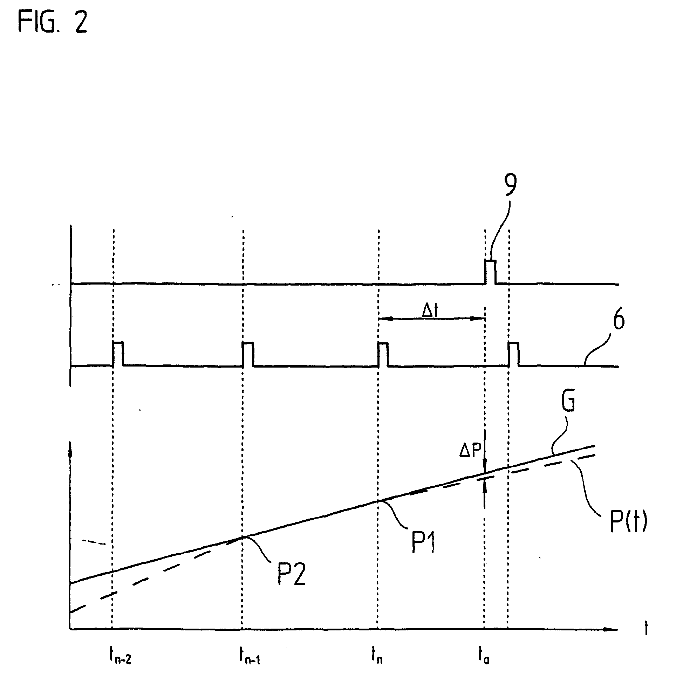

Die so gewonnenen Positionswerte werden dann an eine Extrapolationseinheit 5 weitergereicht. Zum weiteren Ablauf der Positionsmessung sei auch auf Figur 2 verwiesen.

Erhält nun das Positionsmeßgerät 1 eine Anforderung (Triggersignal 9) für eine Positionsmessung von einer übergeordneten Steuerungseinheit 8, so wird in einem Zeitmesser 7 die Zeitspanne Δt vom letzten Puls des internen Taktes bei tn bis zum Eintreffen des Triggersignales 9 zum Zeitpunkt t0 bestimmt. Der Zeitmesser 7 kann zum Beispiel ein Time to Digital Converter (TDC) sein, der vom internen Takt 6 jeweils auf 0 gesetzt wird, und intern eine Zeitspanne Δt sehr genau mißt, die nach Eingang des Triggersignals 9 digital ausgegeben wird.

Diese Zeitspanne Δt wird nun ebenfalls an die Extrapolationseinheit 5 geleitet. Dort wird über eine Funktion, die an mindestens die beiden zu den Zeitpunkten tn und tn-1 erfaßten Positionswerte P1 und P2 angenähert wird, eine Extrapolation für die Position zum Zeitpunkt t0 durchgeführt. Dies bringt Vorteile: bei einem ruhenden Objekt ergibt eine lineare Extrapolation mit zwei Positionswerten eine Mittelung der Position und damit ein Absenken des Rauschens. Für ein mit konstanter Geschwindigkeit bewegtes Objekt ist die Extrapolation immerhin noch sehr genau. Um Vorteile hinsichtlich einer Rauschverminderung zu erhalten, muß eine Gerade anhand von drei Stützpunkten extrapoliert werden. Für beschleunigte Systeme muß auf Funktionen höherer Ordnung (etwa Polynome) zurück gegriffen werden, um noch genaue Extrapolationen zu erhalten. Kennt man jedoch die maximal auftretenden Beschleunigungen, kann man sich auf lineare Extrapolation beschränken, wenn der dadurch auftretende Fehler klein genug bleibt. In der Figur 2 sind dazu der reale Positionsverlauf P(t) eines Objektes mit Beschleunigung in einer Richtung gezeigt, zusammen mit den beiden zu den Zeitpunkten tn und tn-1 erfaßten Positionswerten P1 und P2. ΔP gibt den Fehler einer Positionsberechnung mit linearer Extrapolation einer Geraden G durch P1 und P2 an. Für den beschriebenen Anwendungsfall muß man mit Beschleunigungen des Maskentisches mit bis zu 10g rechnen, bei einem internen Takt 6 von 1MHz ergibt sich so für Δt = 1µs ein maximaler Extrapolationsfehler ΔP von 0,05nm.

Der so bestimmte Positionswert ist also eine Näherung an den geforderten Positionswert des bewegten Objektes zum Zeitpunkt t0. Er wird vom Positionsmeßgerät 1 an die übergeordnete Steuereinheit übergeben.

Um die Vorteile der Rauschunterdrückung durch Mittelwertbildung einerseits und die exakte Bestimmung der Position zum Zeitpunkt t0 andererseits optimal nutzen zu können, ist es auch denkbar, die Extrapolation der jeweiligen Situation flexibel anzupassen. So kann bei einem wenig beschleunigten beweglichen Objekt eine lineare Extrapolation mit vielen Punkten erfolgen, und so eine hohe Rauschunterdrückung erreicht werden, bei stark und nicht konstant beschleunigten Objekten hingegen auf eine Extrapolation höherer Ordnung zurückgegriffen werden, um die Abweichung ΔP klein zu halten.

Ein weiterer Vorteil dieses Positionsmeßgerätes ist es, daß Signallaufzeiten berücksichtigt werden können, die sonst das Meßergebnis verfälschen können. So benötigt etwa das Licht von einem Maßstab zur Detektoreinheit 2 eine bestimmte Zeit, die Folgeelektronik in der Detektoreinheit 2, dem A/D-Wandler 3 und der Verarbeitungseinheit 4 trägt weiter zu Verzögerungen des Meßsignals bei. Diese Effekte können durch einen Offset für die im Zeitmesser 7 bestimmte Zeitspanne Δt berücksichtigt werden.

## Patentansprüche

1. Positionsmeßgerät zur Bestimmung der Position eines beweglichen Objektes mit einer Detektoreinheit (2), mindestens einem von einem internen Takt (6) gesteuerten A/D-Wandler (3), einer Verarbeitungseinheit (4) und einer Extrapolationseinheit (5), und weiter einem Zeitmesser (7) zum Erfassen einer Zeitspanne (Δt) zwischen einem Puls des internen Taktes (6) und einem externen Triggersignal (9), dazu in der Lage die Positionssignale der Detektoreinheit (2) in Zeitintervallen des internen Takts (6) im A/D-Wandler (3) zu digitalisieren und in der Verarbeitungseinheit (4) zu Positionsdaten (P1, P2) zu verarbeiten, und dazu ausgebildet, dass die Extrapolationseinheit (5) einen Positionswert zum Zeitpunkt (t0) des Auftretens des externen Triggersignals (9) aus wenigstens zwei Positionsdaten (P1, P2) extrapoliert.

2. Positionsmeßgerät nach Anspruch 1, wobei die Detektoreinheit (2) ein Abtastkopf eines optischen Gittermeßsystems ist.

3. Verfahren zur Positionsbestimmung in einem Positionsmeßgerät mit folgenden Schritten:
- Digitalisierung von analogen Positionssignalen einer Detektoreinheit (2) in einem A/D-Wandler (3), in Zeitintervallen eines internen Taktes (6),
- Berechnung von Positionsdaten (P1, P2) aus den digitalisierten Signalen in einer Verarbeitungseinheit (4),
- Bestimmung einer Zeitspanne (Δt) zwischen einem Impuls des internen Taktes (6) bis zum Auftreten eines externen Triggersignales (9) in einem Zeitmesser (7),
- Verarbeitung von wenigstens zwei Positionsdaten (P1, P2) zusammen mit der Zeitspanne (Δt) in einer Extrapolationseinheit (5), um einen Positionswert zum Zeitpunkt (t0) des Auftretens des externen Triggersignals (9) aus den wenigstens zwei Positionsdaten (P1, P2) zu extrapolieren.

4. Verfahren nach Anspruch 3, wobei die Zeitspanne (Δt) von einem Zeitmesser (7) gemessen wird, der durch den internen Takt (6) jeweils zurück gesetzt wird, und der nach Empfang des Triggersignals (9) die seit der letzten Rücksetzung vergangene Zeitspanne (Δt) an die Extrapolationseinheit (5) ausgibt.

5. Verfahren nach Anspruch 3, wobei in der Extrapolationseinheit (5) eine Extrapolation mittels einer Polynomfunktion durchgeführt wird, um einen Positionswert zum Zeitpunkt (t0) des Eintreffens des Triggersignals (9) zu berechnen.

6. Verfahren nach Anspruch 5, wobei zur Bestimmung der Polynomfunktion mehr zu früheren Zeitpunkten (tn, tn-1,...) berechnete Positionswerte (P1, P2,...) herangezogen werden als mathematisch nötig, und so eine Mittelung zur Rauschunterdrückung erzielt wird.

7. Lithographiesystem mit einem Positionsmeßgerät nach einem der Ansprüche 1 - 2.

8. Lithographiesystem mit einem Positionsmeßgerät, das nach einem Verfahren nach einem der Ansprüche 3 - 6 arbeitet.

## Claims

1. A position measuring device for determining the position of a movable object comprising a detector unit (2), at least one A/D converter (3) controlled by means of an internal clock (6), a processing unit (4) and an extrapolation unit (5) and further comprising a timing device (7) for measuring a time period (Δt) between a pulse of the internal clock (6) and an external triggering signal (9), being capable of digitizing the positional signals of the detector unit (2) in time intervals of the internal clock (6) in the A/D converter (3) and to process them into positional data (P1, P2) in the processing unit (4) and being embodied for the extrapolation unit (5) to extrapolate a positional value from at least two positional data (P1, P2) at the point in time (t0) of the occurrence of the external triggering signal (9).

2. The position measuring device according to claim 1, wherein the detector unit (2) is a scanning head of an optical grid measuring system.

3. A method for determining the position in a position measuring device comprising the following steps:
- digitizing analog positional signals of a detector unit (2) in an A/D converter (3) into time intervals of an internal clock (6),
- computing positional data (P1, P2) form the digitized signals in a processing unit (4),
- determining a time period (Δt) between an pulse of the internal clock (6) until the occurrence of an external triggering signal (9) in a timing device (7),
- processing at least two positional data (P1, P2) together with the time period (Δt) in an extrapolation unit (5), so as to extrapolate a positional value from the at least two positional data (P1, P2) at the point in time (t0) of the occurrence of the external triggering signal (9).

4. The method according to claim 3, wherein the time period (Δt) is measured by means of timing device (7), which is in each case reset by means of the internal clock (6), and which outputs the time period (Δt) lapsed since the last reset back to the extrapolation unit (5) after receipt of the triggering signal (9).

5. The method according to claim 3, wherein an extrapolation is carried out in the extrapolation unit (5) by means of a polynominal function, so as to compute a positional value at the point in time (t0) of the arrival of the triggering signal (9).

6. The method according to claim 5, wherein more positional values (P1, P2, ...) computed at earlier points in time (tn, tn-1, ...) than are mathematically necessary are used to determine the polynominal function and an averaging is thus attained for the purpose of noise suppression.

7. A lithography system comprising a position measuring device according to one of claims 1-2.

8. The lithography system comprising a position measuring device, which operates according to a method according to one of claims 3-6.

## Revendications

1. Dispositif de mesure de position pour la détermination d'un objet mobile, avec une unité de détection (2), au moins un convertisseur A/D (3) commandé par un générateur de cadence interne (6), une unité de traitement (4) et une unité d'extrapolation (5), ainsi qu'un chronomètre (7) pour la détection d'une plage de temps (Δt) entre une impulsion du générateur de cadence interne (6) et un signal déclencheur externe (9), capable de numériser les signaux de position de l'unité de détection (2) par intervalles de temps du générateur de cadence interne (6) dans le convertisseur A/D (3), et de les convertir en données de position (P1, P2) dans l'unité de traitement (4), et conçu de manière à ce que l'unité d'extrapolation (5) extrapole une valeur de position à l'instant (t0) de l'apparition du signal déclencheur externe (9) à partir d'au moins deux données de position (P1, P2).

2. Dispositif de mesure de position selon la revendication 1, dans lequel l'unité de détection (2) est une tête d'exploration d'un système de mesure optique à grille.

3. Procédé pour la détermination de la position dans un dispositif de mesure de position, avec les étapes suivantes :
- numérisation de signaux de position analogiques d'une unité de détection (2) dans un convertisseur A/D (3), par intervalles de temps d'un générateur de cadence interne (6),
- calcul de données de position (P1, P2) à partir des signaux numérisés, dans une unité de traitement (4),
- détermination d'une plage de temps (Δt) entre une impulsion du générateur de cadence interne (6) et l'apparition d'un signal déclencheur externe (9) dans un chronomètre (7),
- traitement d'au moins deux données de position (P1, P2) ensemble avec la plage de temps (Δt), dans une unité d'extrapolation (5), pour extrapoler une valeur de position à l'instant (t0) de l'apparition du signal déclencheur externe (9) à partir des au moins deux données de position (P1, P2).

4. Procédé selon la revendication 3, dans lequel la plage de temps (Δt) est mesurée par un chronomètre (7), qui est à chaque fois réinitialisé par le générateur de cadence interne (6), et qui, après réception du signal déclencheur (9), transmet la plage de temps (Δt) écoulée depuis la dernière réinitialisation à l'unité d'extrapolation (5).

5. Procédé selon la revendication 3, dans lequel une extrapolation est exécutée dans l'unité d'extrapolation (5) au moyen d'une fonction de polynôme, afin de calculer une valeur de position à l'instant (t0) de l'apparition du signal déclencheur (9).

6. Procédé selon la revendication 5, dans lequel, pour la détermination de la fonction polynôme, plus de valeurs de position (P1, P2,...) calculées à des instants antérieurs (tn, tn-1,...) sont utilisées que mathématiquement nécessaire, permettant ainsi d'atteindre une moyenne pour la suppression du bruit.

7. Système de lithographie, avec un dispositif de mesure de position selon l'une des revendications 1 à 2.

8. Système de lithographie, avec un dispositif de mesure de position travaillant conformément à un procédé selon l'une des revendications 3 à 6.
